(19) Europäisches Patentamt
European Patent Office
Office européen des brevets

(11) **EP 4 550 664 A1**

(12) **EUROPEAN PATENT APPLICATION**

(43) Date of publication:
**07.05.2025 Bulletin 2025/19**

(21) Application number: **24207766.7**

(22) Date of filing: **21.10.2024**

(51) International Patent Classification (IPC):
**H03H 7/01** $^{(2006.01)}$

(52) Cooperative Patent Classification (CPC):
**H03H 7/0115; H03H 7/466**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.10.2023 US 202318498601**

(71) Applicant: **Avago Technologies International
Sales
Pte. Limited
Singapore 768923 (SG)**

(72) Inventor: **Babamir, Seyed Mehrdad
Irvine, 92618 (US)**

(74) Representative: **Bosch Jehle
Patentanwaltsgesellschaft mbH
Flüggenstraße 13
80639 München (DE)**

(54) **OUT-OF BAND FILTERS**

(57) Wide-band matching in out-of-band blocker rejection filters is provided. A device includes a first inductor. The device includes a second inductor magnetically coupled with the first inductor and with an amplifier. The device includes a notch filter electrically coupled between the first inductor and the second inductor. The amplifier can be configured to amplify a plurality of radio frequency signals. A bandwidth of the radio frequency signals can exceed 1.5 gigahertz (GHz).

FIG. 2

Processed by Luminess, 75001 PARIS (FR)

**Description**

This disclosure generally relates to systems and methods for signal amplification and transmission. Particularly, the disclosure relates to filters that may be employed as input filters for amplification circuits, such as radio frequency (RF) amplifiers.

In the last few decades, the market for wireless communications devices has grown by orders of magnitude, fueled by the use of portable devices, and increased connectivity and data transfer between all manners of devices. Digital switching techniques have facilitated the large-scale deployment of affordable, easy-to-use wireless communication networks. Furthermore, digital and radio frequency (RF) circuit fabrication improvements, as well as advances in circuit integration and other aspects have made wireless equipment smaller, cheaper, and more reliable. Wireless communication can operate in accordance with various standards such as IEEE 802.1 1x, Bluetooth, global system for mobile communications (GSM), and code division multiple access (CDMA). As higher data throughput, density of networks, and other changes develop, newer standards are constantly being developed for adoption. Many devices can include multi-device radios, antennae or other components. Such multi-mode devices can operate across various protocols, power levels, frequencies, and so forth.

According to an aspect, a device is provided comprising:

> a first inductor;
> a second inductor magnetically coupled with the first inductor and with an amplifier;
> a notch filter electrically coupled between the first inductor and the second inductor; and
> wherein the amplifier is configured to amplify a plurality of radio frequency signals, wherein a bandwidth of the plurality of radio frequency signals exceeds 1.5 gigahertz (GHz).

Advantageously:
the second inductor is directly coupled to a gate terminal of the amplifier.

Advantageously the device further comprises:
a multi-tap inductor, wherein:

> a first tap pair of the multi-tap inductor corresponds to a first terminal of the first inductor and a second terminal of the first inductor; and
> a second tap pair of the multi-tap inductor corresponds to a third terminal of the second inductor and a fourth terminal of the second inductor.

Advantageously:

> the first terminal couples with the third terminal;
> a terminal of the notch filter couples with the first terminal and the third terminal; and

another terminal of the notch filter couples with a reference voltage.

Advantageously, the device further comprises a capacitor having:

> a first terminal which couples with the first terminal and the third terminal; and
> a second terminal which electrically couples with a third inductor, wherein the third inductor couples with a third tap pair of the multi-tap inductor.

Advantageously, the multi-tap inductor is a multi-tap spiral inductor.

Advantageously, the device is formed along a planar surface of a semiconductor die.

According to an aspect, a system is provided comprising:

> a first inductor, having a first terminal and a second terminal;
> a second inductor having a first terminal electrically coupled with the second terminal of the first inductor at a first node, the second inductor magnetically coupled with the first inductor;
> a filter coupled with the first node; and
> an amplifier electrically coupled with a second terminal of the second inductor, the amplifier to amplify a plurality of signals, each signal of the plurality of signals corresponding with at least one center frequency.

Advantageously:
the plurality of signals comprise signals corresponding to center frequencies in a 5 GHz band and signals corresponding to center frequencies in a 6 GHz band.

Advantageously:

> a first center frequency corresponding with a first signal of the plurality of signals exceeds five gigahertz (GHz); and
> a second center frequency corresponding with a second signal of the plurality of signals exceeds the first center frequency by more than one GHz.

Advantageously, the system comprises:
a multi-tap inductor, wherein:

> a first tap of the multi-tap inductor corresponds to the first terminal of the first inductor;
> a second tap of the multi-tap inductor corresponds to the second terminal of the first inductor;
> a third tap of the multi-tap inductor corresponds to the first terminal of the first inductor; and
> a fourth tap of the multi-tap inductor corresponds to the second terminal of the first inductor.

Advantageously:

the second tap is coupled with the third tap; and
a filter separates the second tap and the third tap
from a reference voltage.

Advantageously:

the filter is a notch filter comprising a first capacitor
and a third inductor, the third inductor comprising a
first terminal and a second terminal; and
the reference voltage is a ground voltage.

Advantageously:
the multi-tap inductor comprises a fifth tap corresponding
to the first terminal of the third inductor, and a sixth tap
corresponding to the second terminal of the third inductor.

Advantageously, the multi-tap inductor is a multi-tap spiral inductor.

Advantageously, the first inductor, the second
inductor, and a third inductor are formed along a planar
surface of a semiconductor die.

According to an aspect, a method is provided
comprising:

receiving, from an antenna, a plurality of signals,
each signal of the plurality of signals corresponding
with at least one center frequency;
resonating, at a filter, at a first center frequency of a
first signal of the plurality of signals, the filter:

being separated from the antenna by a first
inductor;
being separated from an amplifier by a second
inductor; and
comprising a first capacitor in series with at least
a third inductor; and receiving, at a gate terminal:

a second signal of the plurality of signals,
the second signal comprising second spectral
content corresponding to a second center
frequency; and
a third signal of the plurality of signals, the
third signal comprising third spectral content
corresponding to a third center frequency.

Advantageously, the method further comprises:

determining first digital content from the second
spectral content; and
determining second digital content from the third
spectral content.

Advantageously, the second spectral content
and the third spectral content are received, simultaneously, by the antenna.

Advantageously, the first inductor, the second
inductor, and the third inductor of the filter are portions of a
multi-tap spiral inductor formed along a planar surface.

## Brief Description of the Drawings

Various objects, aspects, features, and advantages of the disclosure will become more apparent and
better understood by referring to the detailed description
taken in conjunction with the accompanying drawings, in
which like reference characters identify corresponding
elements throughout. In the drawings, like reference
numbers generally indicate identical, functionally similar,
and/or structurally similar elements.

FIG. 1 is a schematic block diagram of a radio
frequency amplification circuit, according to some
embodiments.

FIG. 2 is another schematic block diagram of a radio
frequency amplification circuit, according to some
embodiments.

FIG. 3 is a detail view of a circuit for filtering a radio
frequency signal, according to some embodiments.

FIGS. 4, 5, 6, and 7 are logical transformations of the
circuit of FIG. 3, according to some embodiments.

FIG. 8 is yet another schematic block diagram of a
radio frequency amplification circuit, according to
some embodiments.

FIGS. 9, 10, and 11 depict inductor geometries,
according to some embodiments.

FIG. 12 is a flow diagram showing operations for a
method, according to some embodiments.

The details of various embodiments of the
methods and systems are set forth in the accompanying
drawings and the description below.

## Detailed Description

The following disclosure provides many different embodiments, or examples, for implementing different features of the provided subject matter. Specific examples of components and arrangements are described
below to simplify the present disclosure. These are, of
course, merely examples and are not intended to be
limiting. The present disclosure may repeat reference
numerals and/or letters in the various examples. This
repetition is for the purpose of simplicity and clarity and
does not in itself dictate a relationship between the various embodiments and/or configurations discussed.

Some embodiments disclosed herein are related to a device. The device can include a first inductor.
The device can include a second inductor. The second
inductor can be magnetically coupled with the first inductor and an amplifier. The device can include a notch filter. The notch filter can be electrically coupled between the first inductor and the second inductor. The amplifier can be configured to amplify radio frequency signals. A bandwidth of the radio frequency signals can exceed 1.5 gigahertz (GHz).

In some embodiments, the second inductor is directly coupled to a gate terminal of the amplifier. In some embodiments, the device includes a multi-tap inductor. A first tap pair of the multi-tap inductor can correspond to a first terminal of the first inductor and a second terminal of the first inductor. A second tap pair of the multi-tap inductor can correspond to a third terminal of the second inductor and a fourth terminal of the second inductor. In some embodiments, the first terminal couples with the third terminal. A terminal of the notch filter can couple with the first terminal and the third terminal. Another terminal of the notch filter can couple with a reference voltage (e.g., a ground). In some embodiments, the device includes a capacitor. A first terminal can couple with the first terminal and the third terminal. A second terminal can electrically couple with a third inductor, the third inductor coupled with a third tap pair of the multi-tap inductor. The multi-tap inductor can be a multi-tap spiral inductor. The device can be formed along a planar surface of a semiconductor die.

Some embodiments disclosed herein are related to a system. The system can include a first inductor, having a first terminal and a second terminal. The system can include a second inductor having a first terminal electrically coupled with the second terminal of the first inductor at a first node, the second inductor magnetically coupled with the first inductor. The system can include a filter coupled with the first node. The system can include an amplifier electrically coupled with a second terminal of the second inductor, the amplifier to amplify various signals. Each of the various signals can correspond with at least one center frequency.

In some embodiments, the signals include signals corresponding to center frequencies in a 5 GHz band and signals corresponding to center frequencies in a 6 GHz band. In some embodiments, a first center frequency corresponding with a first signal exceeds five gigahertz (GHz). A second center frequency corresponding with a second signal can exceed the first center frequency by more than one GHz. In some embodiments, the system includes a multi-tap inductor. A first tap of the multi-tap inductor can correspond to the first terminal of the first inductor. A second tap of the multi-tap inductor can correspond to the second terminal of the first inductor. A third tap of the multi-tap inductor can correspond to the first terminal of the first inductor. A fourth tap of the multi-tap inductor can correspond to the second terminal of the first inductor. In some embodiments, the second tap is coupled with the third tap. A filter can separate the second tap and the third tap from a reference voltage.

In some embodiments, the filter is a notch filter comprising a first capacitor and a third inductor, the third inductor comprising a first terminal and a second terminal. The reference voltage can be ground voltage. In some embodiments, the multi-tap inductor includes a fifth tap corresponding to the first terminal of the third inductor, and a sixth tap corresponding to the second terminal of the third inductor. In some embodiments, the multi-tap inductor is a multi-tap spiral inductor. In some embodiments, the first inductor, the second inductor, and a third inductor are formed along a planar surface of a semiconductor die.

Some embodiments disclosed herein are related to a method. The method can include receiving, from an antenna, various signals, each of which corresponds with at least one center frequency. The method can include resonating, at a filter, at a first center frequency of a first signal of the plurality of signals. The filter can be separated from the antenna by a first inductor. The filter can be separated from an amplifier by a second inductor. The filter can include a first capacitor in series with at least a third inductor. The method can include receiving, at a gate terminal, second and third signals. The second signal can include second spectral content corresponding to a second center frequency. The third signal can include third spectral content corresponding to a third center frequency.

In some embodiments, the method includes determining first digital content from the second spectral content and second digital content from the third spectral content. In some embodiments, the second spectral content and the third spectral content are received, simultaneously, by the antenna. In some embodiments, the first inductor, the second inductor, and the third inductor of the filter are portions of a multi-tap spiral inductor formed along a planar surface.

An amplifier, such as a low noise amplifier for a radio frequency (RF) circuit can receive wideband input signals such as signals corresponding to a WiFi, Bluetooth, cellular telephones, or other wireless communications protocols. An antenna or other input can also receive interfering signals, which can saturate the amplifier, which may make it difficult to determine a content of the wideband input signals. A circuit to provide wideband input matching while rejecting the interfering signals can avoid such saturation. A transmission line can provide wideband matching, wherein a notch filter (e.g., a high-Q filter peaking at the interference frequency) can "notch out" the interfering signal. However, manufacturing such a transmission line be challenging due to components sizes for the wideband input signals

A lumped-model of the transmission line can improve an input bandwidth to the amplifier, while rejecting an interfering frequency, according to the inclusion of a notch filter. For example, the lumped-model can be implemented as a tee-filter separating the antennae from the amplifier. The tee-filter can provide wide band filtering (e.g., GHz range, such as 1.5 GHz or greater).

The tee-filter can be implemented as a T-coil, which can enhance input bandwidth, and reduce circuit area, relative to other approaches. The T-coil can be implemented along a planar surface of a semiconductor device (e.g., a die), such as along one or more metallization layers formed thereover. The mutual inductance of the coils, in combination with omitting duplications of shielding, spacing, or other circuit portions associated with inductors can reduce a circuit area consumed, relative to other approaches. Moreover, an input inductor (also referred to as a gate inductor) of the amplifier, any inductors of the notch filter, or other proximal inductors can be included in a same pattern, the pattern including multiple taps, so as to further reduce area consumed by the circuit. An inductor may refer to or include a conductive element to store energy in a magnetic field according to a current flow through the conductive element. For example, the conductive element can include a wound wire, spiral planar inductor, or other inductor geometries.

For clarity of the disclosure, before proceeding with further description of the systems and methods provided herein, illustrative descriptions of various terms are provided:

An amplifier may refer to or include an electronic device designed, configured, or operable to increase a strength of an electronic signal, in some embodiments. For example, the amplifier can amplify a voltage or current. The amplifier may output a signal, based on an input signal, between a maximum and minimum output (e.g., rails). Reaching a rail may be referred to as saturation, in some embodiments.

A filter may refer to or include a circuit to selectively pass or reject certain frequencies or components of a signal, in some embodiments. A filter may be used to modify a shape or frequency response of a signal, such as to selectively pass signals in a first frequency range and selectively reject signals outside of the first frequency range. A filter can be or include a notch filter. A notch filter may refer to or include a circuit configured to include a passband, and include frequency rejection for some frequencies greater than the pass band, and other frequencies lower than the pass band, in some embodiments. The notch filter can have one or more center frequencies, such as a center frequency corresponding to a resonance between an inductor and a capacitor. Notch filters in the RF range can have various other center frequencies corresponding to various parasitic capacitances, so as to define a frequency response curve of the notch.

A multi-tap inductor may refer to or include an inductor terminating at a first end, a second end, and including one or more additional terminals, in some embodiments. For example, the multi-tap inductor can include a center terminal, or additional terminals paired to correspond to electrically separate portions of the multi-tap inductor (which may also be referred to as separate inductors, such as a first, second, or third inductor). A terminal may refer to or include a conductive element connected to an inductor coil or other component configured for electrical coupling to another element, such as a gate terminal, or a further inductor, in some embodiments. A gate terminal may refer to or include a terminal in electrical contact with a gate, in some embodiments. For example, the gate can be a gate of a transistor, relay, or silicon controlled rectifier, wherein a voltage applied to the gate terminal can switch a conduction channel (e.g., of the transistor). A terminal pair, which may also be referred to as a tap pair in conjunction with a multi-tap inductor, may refer to or include two terminals (or 'taps') disposed on opposite ends of an inductive coil or other device, in some embodiments. For example, the inductive coil can be one of any number of inductive coils of the multi-tap inductor. A multi-tap spiral inductor may refer to or include a multi-tap inductor including features which are disposed over a two dimensional plane, in some embodiments. For example, a spiral inductor can be formed over one or more layers of a printed circuit board, metallization layers of a semiconductor device, or so forth. The spiral inductor can include vertical portions, such as vias to pass a conductive element over or under a portion of a coil, or stacked portions to generate a three-dimensional shape over the various two-dimensional planes. A planar surface may refer to or include any one or more layers (e.g., of the printed circuit boards, metallization layers, etc.), in some embodiments.

A reference voltage may refer to or include a predefined voltage level configured for the purpose of measurement, regulation, or comparison with other voltage levels, in some embodiments. For example, the reference voltage may refer to or include a ground voltage, which may refer to or include a zero-potential reference corresponding to a chassis, power plane, redistribution structure, shield-ground, signal-ground, power-ground, floating ground, or so forth, in some embodiments. A reference voltage can include a bias voltage, which may refer to or include a voltage which is offset from the ground voltage, in some embodiments.

A semiconductor die may refer to or include a semiconductor material such as silicon or germanium, having an active surface, in some embodiments. The active surface can include n-wells and p-wells for diodes and transistors, films or dopants for resistors, or polysilicon resistors or capacitors. Various interconnects of a metallization layer disposed over the semiconductor die can form further features, such as inductors, spiral resistors, metal-insulation-metal capacitors, and so forth.

A node may refer to or include a position on an electronic circuit that can be analyzed for a voltage, current, or other attributes, in some embodiments. For example, a node can include a junction between two or more active or passive devices (e.g., at terminals thereof).

A signal may refer to or include a time-varying electrical, electromagnetic, or optical waveform that can carry information, in some embodiments. For example, a signal can include information corresponding to symbols that can be retrieved to generate digital data according to a predefined symbolic representation. A signal can include one or more constituent signals. For example, a signal received at an antenna can include a first signal from a first device, a second signal from a second device, a third signal from a third device, or so forth. For example, at least one of the signals can include information corresponding to a system including the antenna, and one or more signals can include information which is not intended to correspond to the system (e.g., interference). For example, signals can include information relating to a center frequency of a powerline, which may be described as interference with regard to one or more systems. A radio frequency (RF) signal may refer to or include a signal including one or more components in the RF range, which can extend from a kilohertz range to a GHz range (e.g., into the hundreds of GHz), in some embodiments.

A band may refer to or include a specific range of frequencies within the electromagnetic spectrum, in some embodiments. For example, a band can include a predefined set of frequencies that are defined according to an implementation or standard (e.g., Bluetooth, Wi-Fi, or cellular communications standard). For example, a 5 GHz band may refer to or include frequency ranges between about 5 and 6 GHz, in some embodiments. For example, 5 GHz bands of a Wi-Fi communication links can include one or more bands extending from 5150 MHZ to 5895 MHz. A 6 GHz band may refer to or include frequency ranges between about 6 and 7 GHz, in some embodiments. For example, 6 GHz bands of a Wi-Fi communication links can include one or more bands extending from 5925 MHz to 7125 MHz. One or more bands (e.g., corresponding to 20 MHz, 40 MHz, or 320 MHz of bandwidth) may be referred to based on a center frequency, which may refer to or include a center point of the bands. For example, a center point of channel 44 of a 5 GHz Wi-Fi band, extending from 5210 MHz to 5230 MHz is disposed at 5220 MHz. Spectral content may refer to or include information of a signal, the information disposed within a band thereof, in some embodiments. For example, spectral content can refer to symbols conveyed over a band. Content of a message may refer to information in a body of a message, header of a message, preamble of a message, or the like, in some embodiments.

Resonating may refer to or include constraining energy within a portion of a circuit according to a frequency thereof, in some embodiments. For example, a notch filter can resonate at a frequency defined according to the components thereof. The energy constrained within the circuit portion can dissipate according to (e.g., resistive) losses associated therewith, which may reduce spectral content at the resonating frequency in other portions of a circuit.

Separation may refer to or include a physical or electrical separation of two components by a third component, in some embodiments. For example, the third component can intermediate the first two components such that the first two components may be referred to as indirectly coupled, or can connect to the first two components at a common node.

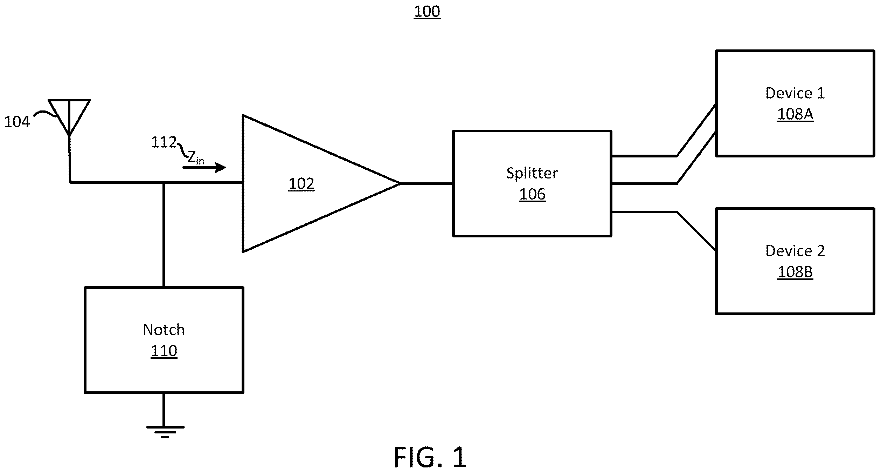

FIG. 1 depicts a schematic block diagram of a radio frequency amplification circuit 100, according to some embodiments. The circuit 100 can be configured to operate along various frequency bands. For example, the circuit 100 can operate across various bands of a wireless protocol such as a wireless fidelity (Wi-Fi) protocol, or across various wireless protocols such as WiFi, Bluetooth, cellular communication protocols, and so forth. The circuit 100 can include a low-noise amplifier 102 configured to receive a signal from an input port such as an antenna 104. The signal can include content distributed across one or more channels, such as channels exhibiting spectral diversity. For example, the antenna 104 can be a wideband antenna configured to receive various signals, such as WiFi signals in a five or six GHz band (e.g., between 5.15-7.125 GHz), in a 2.4 GHz band (e.g., 2.4-2.5 GHz), or other signals such as Bluetooth content (e.g., in a 2.4-2.49 GHz range), cellular telephone signals, or so forth.

The amplifier 102 can output a signal to one or more devices (or terminals configured to connect to further devices). For example, the amplifier 102 can couple to a splitter 106 to connect to multiple devices 108, or to convey multiple bands or signals to a single device 108. The depicted devices 108 can extend in frequency greater than other approaches, such as greater than 1.5GHz. For example, the outputs can correspond to a content of a 5 GHz and 6 GHz WiFi bands, or greater than 4 GHz to operate with further 2.4 GHz bands of WiFi or Bluetooth systems. The circuit 100 can be implemented on or include one or more silicon dies, multi-die packages, circuit boards, or the like.

The antenna 104 can receive various incidental signals or interference, such as wireless transmissions from radar systems, cordless phones, powerline interference (e.g., fifty or sixty Hz), and so forth. A filter (e.g., the depicted notch filter 110) can be configured to pass a band select frequency range corresponding to a bandwidth of the amplifier 102. The input impedance 112 to the amplifier 102 can vary over frequency, according to the frequency response of the notch filter 110. For a frequency of interest, the notch filter can be adjusted to increase an input impedance thereto. However, the adjustments may be targeted to a center frequency of operation, wherein the wideband operation can exceed a band rejection of the notch filter 110.

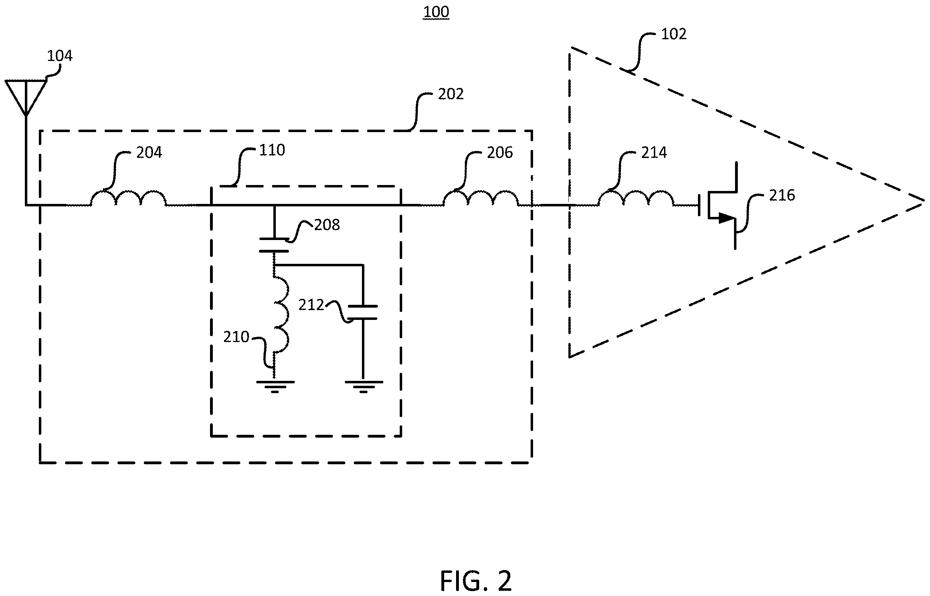

Referring now to FIG. 2, another schematic block diagram of a radio frequency amplification circuit 100 is provided, according to some embodiments. The schematic block diagram is provided as a functional schematic, and does not necessarily correlate to a physical placement of any particular component. A filter 202 (e.g., a tee-filter 202) separates the antenna 104 from the amplifier 102. A series arm of the tee-filter 202 includes a first inductor 204 and second inductor 206, the first inductor 204 and second inductor 206 disposed opposite from a shunt arm. The shunt arm includes a notch filter 110 between the coupled terminals of the inductors 204, 206 and a reference voltage, which can include a DC reference voltage such as a bias voltage or one of various grounds proximal or relevant to the circuit 100.

An illustrative example of a notch filter 110 is provided, the notch filter 110 including an LC section including a first capacitor 208 in series with a filter inductor 210. The first capacitor 208 and the filter inductor 210 can be selected according to a known aggressor or interfering frequency. For example, a center frequency of a "trap" of the LC section can be defined as proportional to the square root of the LC, and particularly, as:

$$f_0 = \frac{1}{2\pi\sqrt{LC}}$$

In various embodiments, the center frequency can further depend on various parasitics, resistances, or other interactions between the depicted elements or interactions with further elements still. For example, a bandwidth (e.g., Q-factor) of the filter can vary according to a resistance thereof, such as according to a construction of the inductors, or addition of diffused, polysilicon, spiral metal, or other resistors. The addition of the second capacitor 212 can generate a series-parallel circuit having a resonance at (neglecting certain second or third order effects, such as the parasitics and resistances described above):

$$f_{L,C_2} = \frac{1}{2\pi\sqrt{L_2 C}}$$

At this frequency, the impedance of the parallel LC circuit is at a local maximum because the reactive impedance of the inductor and capacitor cancel each other out. However, the first capacitor will still contribute to the overall frequency response. Indeed, the filter behavior at RF frequencies will further be influenced by circuit parasitics, such that performance at a particular frequency may correlate strongly with such effects.

At a frequency of interest, the tee-filter 202 can approximate a transmission line. The LC circuit of the first capacitor 208 and the filter inductor 210 can resonate, such that signals passing from the antenna 104 to the amplifier 102 proceed as if the notch filter consists of the second capacitor 212. Thus, the tee-filter 202 operates as a lumped model of a transmission line with a T-coil.

An input (S11) bandwidth of the tee-filter 202 can exceed a range of operating frequencies, such as a bandwidth of greater than 1 GHz, 1.5 GHz (e.g., 2 GHz, 4GHz, etc.). Accordingly, an input impedance 112 seen by the antenna 104 can be relatively flat, and the amplification, by the amplifier 102, can avoid saturation or other clipping that can lose information included in a signal, which may lead to difficulty in reconstructing various symbols carried in the signal, so as to increase a bit error rate, decrease a throughput, or otherwise affect throughput or latency of wireless communication.

In some implementations, such as an on-chip implementations, an inductor (e.g., spiral inductor) can occupy substantial area. In addition to the inductor itself, a guard ring, shield, or other features can be employed to improve a Q-factor, or avoid interference with further circuits of the semiconductor device. Multiple inductors, including the first inductor 204 and second inductor 206, can be mutually coupled. For example, a lithographic pattern can define multiple inductors configured to couple with each other. Such a combination of inductors can be referred to as a multi-tap inductor. The multi-tap inductor may refer to or include an inductor including a first terminal, a second terminal, and at least one terminal between the first and second terminals. The multi-tap inductor can be patterned to include multiple constituent inductors. For example, two intermediate terminals can, for at least some signals (e.g., DC signals), electrically isolate two inductors from each other. Multi-tap inductor patterns can be relatively space-efficient, or dense, even for inductors that are not functionally related. Moreover, a proximity of the windings in multi-tap inductors may aid in mutual coupling therebetween, according to some embodiments.

In an illustrative example, a first tap pair of the multi-tap inductor can correspond to a first and second terminal of one or more inductors. A second tap pair of the multi-tap inductor can correspond to a first and second terminal of one or more other inductors. Terminals of the inductors can be coupled to each other (e.g., the inductors can correspond to the first inductor 204 and second inductor 206). Thus, terminals of a filter (e.g., the notch filter 110) can separate the connected inductor terminals from a reference voltage, such as ground. More particularly, as depicted, the notch filter 110 can include a capacitor 208 coupled to the inductor terminals. For example, the capacitor 208 can couple to the inductor terminals at a first terminal thereof, and to a second capacitor 212 at a second terminal thereof. The second capacitor 212 can be disposed in parallel with a further inductor 210, and connected to ground opposite from the other capacitor 208. In some embodiments, the inductor 210 in parallel with the second capacitor 212 can include terminals corresponding to a third tap pair of the multi-tap inductor.

Further, the amplifier 102 can be or include a low noise amplifier (LNA) 102. An input of the LNA 102 can incorporate an input inductor as part of a matching network to transform the source impedance to an impedance for a transistor 216, increasing power transfer and reducing noise. The input inductor can aid in tuning out parasitic capacitances at the input, enhancing the bandwidth and frequency response of the LNA 102. The reduction in noise can further stabilize a DC operating point of the amplifier 102. Such an input inductor is depicted as a third inductor 214 (sometimes referred to as a gate inductor of the LNA 102), separating the filter 202 from a gate of the amplifier 102. A combination of the third inductor 214 with the second inductor 206 in a same pattern can further aid in area reduction, such as by inclusion in a same (e.g., lithographic) pattern. Moreover, the combination of the first inductor 204 with the second inductor 206 can include a magnetic coupling therebetween, which can improve the S11 bandwidth (e.g., according to a distributed response corresponding to mutual induction and a native capacitance between windings).

As indicated above, the depictions provided herein are provided as a functional schematic, which do not necessarily correlate to a physical placement of the components. For example, a distinction between the second inductor 206 and the third inductor 214 can be defined arbitrarily according to a portion of a same spiral (e.g., can lack a tap or terminal separating the two). Correspondingly, a boundary of the amplifier 102 can be defined arbitrarily. For example, the third inductor 214 (or an inductor comprising the second inductor 206 and the third inductor 214) can be referred to as coupled to the amplifier 204 (e.g., directly coupled to a gate terminal of the amplifier 102) or as a constituent portion of the amplifier 102.

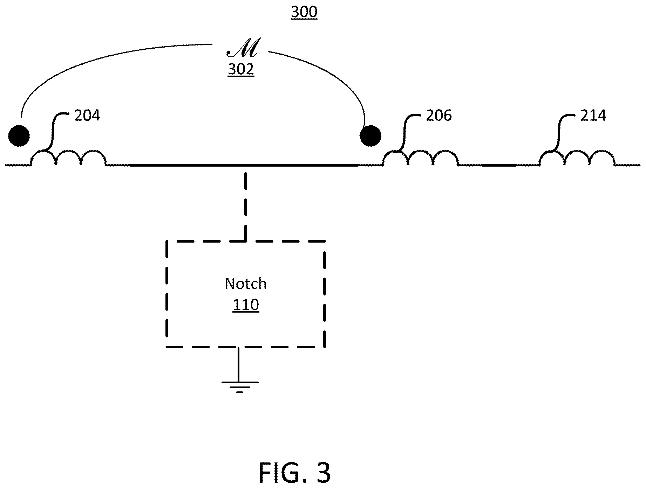

Referring now to FIG. 3, a detail view of a circuit for filtering an RF signal is provided, according to some embodiments. The first inductor 204 and the second inductor 206 of FIG. 2 are shown as mutually coupled, according to a mutual inductance therebetween $\mathcal{M}$ 302. According to various embodiments, the mutual inductance, $\mathcal{M}$ 302 (provided hereinafter by the corresponding inductor dots, merely for clarity) can correspond to interactions between a coil of the first inductor 204 and a coil of the second inductor 206, or a shared correspondence with a core. For example, in some embodiments, the first inductor 204 and the second inductor 206 can be wire-wound inductors wrapped around each other, or around a same core. In some embodiments, the first inductor 204 and the second inductor 206 can be formed along a planar surface of a semiconductor die (e.g., may be spiral inductors). For example, the first inductor 204 and the second inductor 206 can be formed on first and second metallization layers over an active die surface, or in a same metallization layer (e.g., according to a same lithographic pattern, the lithographic pattern including taps to connect to the respective inductors wherein the tapped connections can extend over or below the coils, on a further metallization layer. That is, the first inductor 204 and the second inductor 206 can be constituent portions of a multi-tap spiral inductor.

The multi-tap inductor can further include the third inductor 214. For example, a lithographic pattern, or a metallization layer defined thereby, can define a first portion electrically terminating at a respective tap pair therefor, the first portion corresponding to the first transistor 204. The multi-tap inductor can include a second portion terminating at a respective tap pair therefor, the second portion corresponding to the series combination of the second inductor 206 and third inductor 214. A first segment of the second portion (the first segment corresponding to the second inductor) can be magnetically coupled to the first portion 204. A second segment of the second portion can correspond to the third inductor 214. Respective values for the respective portions can be determined as depicted hereinafter.

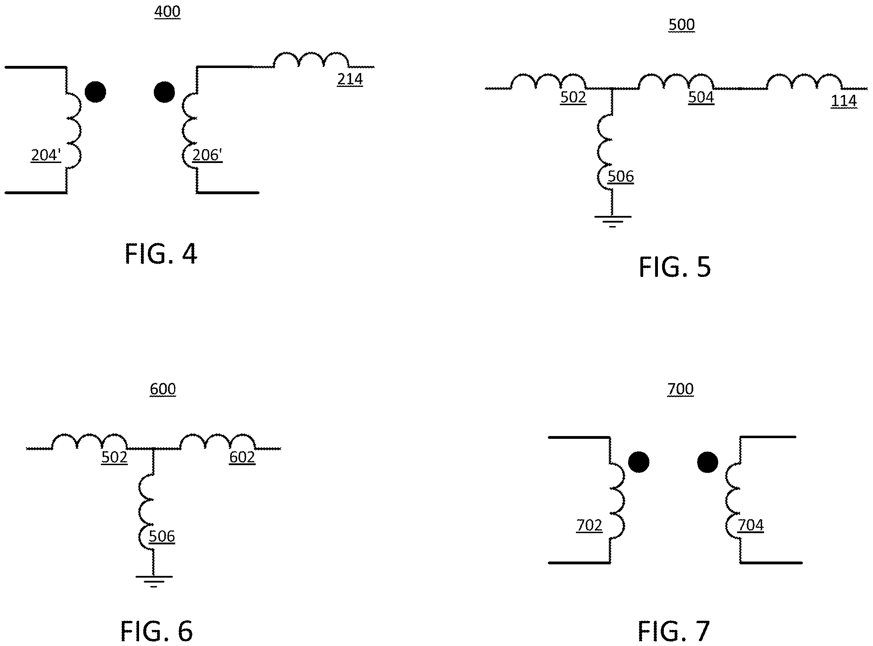

FIG. 4 depicts a first logical transform 400 of the circuit of FIG. 3. A mutual inductance between respective coils of the first inductor 204 and the second inductor 206 is defined according to a turns ratio therebetween, according to:

$$k = \frac{\mathcal{M}}{\sqrt{L_1 L_2}}$$

Of course, the depicted formula is merely intended to describe first order function, wherein particular geometry of a semiconductor device, and various coupling (e.g., magnetic, electrical, mechanical) with further circuit elements can further impact a behavior of a circuit. However, such a transform may aid in approximating circuit behavior, such as to aid in selection of component values for various embodiments of the present disclosure.

Referring now to FIG. 5, a second logical transform 500 of the circuit of FIG. 3 is provided. The series arm of the tee filter 202 is depicted to include a leftmost inductor 502 (corresponding to the first inductor 204, less a mutual inductance portion thereof), a rightmost inductor 504 (corresponding to the second inductor 206, less a mutual inductance portion thereof), and a shunt inductor, corresponding to the mutual inductance 302 portion. The third inductor 114 is depicted as separate from the other inductors. Referring now to FIG. 6, a third logical transform 600 of the circuit of FIG. 3 is provided. The transform combines the rightmost inductor 504 with the third inductor 114 to generate another rightmost inductor 602, an inductance of the rightmost inductor 602 equaling the sum of the rightmost inductor 504 with the third inductor 114 of FIG. 5.

Referring now to FIG. 7, a fourth logical transform 700 of the circuit of FIG. 3 is depicted. The fourth logical transform inverts the transform of FIG. 5, but includes the third inductor. The turns ratio between the depicted left inductor 702 and right inductor 704 can be provided according to:

$$k = \frac{\mathcal{M}}{\sqrt{L_1(L_2 + L_g)}}$$

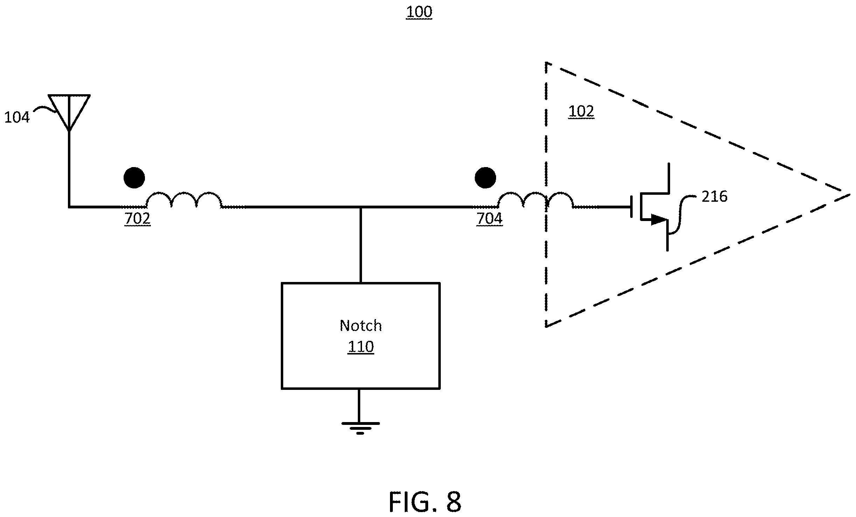

Referring now to FIG. 8, a circuit 100 for filtering an RF signal is provided, according to some embodiments. The circuit 100 can be generated by inverting the logical transform of FIG. 4, and including further elements of the circuit 100 of FIG. 1. The circuit 100 includes a first inductor 702 and a second inductor 704. The inductance, turns ratio, or other attributes of the first inductor 702 and the second inductor 704 can be determined according to the logical transforms of FIGS. 4, 5, 6, or 7.

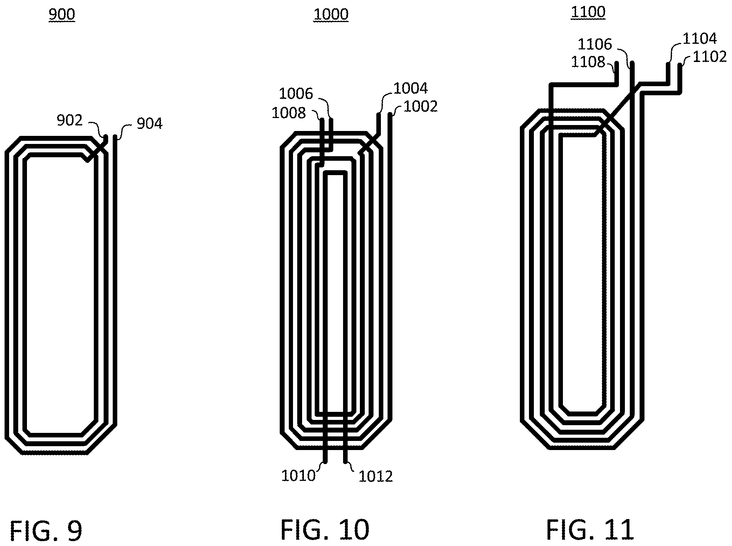

FIG. 9 depicts an example inductor geometry, according to some embodiments. For example, the depicted inductor 900 can be formed in a first metallization layer of a semiconductor device, and configured to couple (e.g., along a z-axis) with another inductor 900 formed on a corresponding layer. A first terminal 902 of the inductor and a second terminal 904 of the inductor are provided for connecting to further portions of a circuit. One or more terminals (e.g., the first terminal 902 as depicted) can pass over or under the inductor coil 900 to connect to a further element. For example, one or more vias, redistribution layers, or so forth can connect the first terminal 902 to another layer of a semiconductor device.

FIG. 10 depicts another example inductor geometry, according to some embodiments. Like the inductor 900 of FIG. 9, the depicted inductor 1000 can be formed on one or more metallization layers of a semiconductor device. A first terminal 1002 and second terminal 1004 (collectively, first tap pair) of the multi-tap inductor can correspond to one inductor. A third terminal 1002 and fourth terminal 1004 (collectively, second tap pair) of the inductor correspond to another inductor. In some embodiments, one of the first tap pair can be connected to one of the second tap pair. For example, the connection of the second terminal 1004 to the third terminal 1006 can yield a shunt arm. Such a shunt arm may be employed to, for example, connect to a reference voltage via a shunt branch, such as to a ground or bias voltage via a notch filter 110. A same pattern can include a further tap pair, depicted according to a fifth terminal 1010 and sixth terminal 1012.

Various geometries can be employed according to various embodiments of the present disclosure. For example, an inner coil (or portion thereof) may be disposed within an outer coil, as depicted with regard to the inner coil terminating at the third terminal 1006 and fourth terminal 1108 and the outer coil terminating at the first terminal 1002 and second terminal 1004. Some coils (or portions thereof) may be configured as alternating, such as the inductor 1100 of FIG. 11. A first coil terminates at the first terminal 1102 and second terminal 1104 alternating with a second coil, the second coil terminating at a third terminal 1106 and fourth terminal 1108. The provided geometries are provided merely to illustrate certain aspects of inductors and should not be construed as limiting. Further, various geometries herein can be combined with each other or further geometries still, so as to realize a desired inductor parameter. Further, one or more dielectrics, shield elements or other circuit components can be selected according to such a desired inductor parameter.

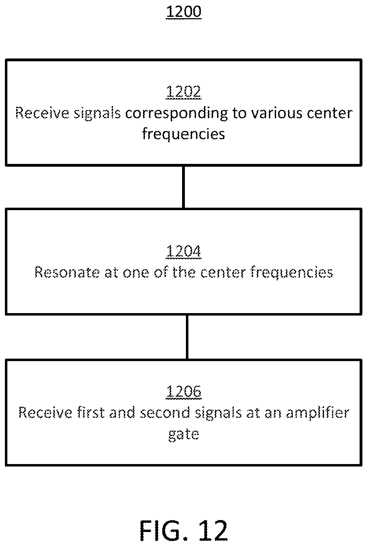

FIG. 12 depicts a method 1200 for circuit operation. At operation 1202, signals having various center frequencies are received. The signals can be received from an antenna 104. The signals can be spectrally or temporally overlapping or exclusive. The signals can include spectral content associated with one or more bands. The bands (e.g., a center frequency thereof) can be separated by one or more GHz, such as 1.5 GHZ, 2 GHz, or 4 GHz. For example, the signals can include a Bluetooth signal or 2.4 GHz Wi-Fi signal and a 5 or 6 GHz Wi-Fi signal. The received signals can include constituent signals at different frequencies, (e.g., 900MHz, 24 GHz, 50/60Hz, etc.), which may include an interfering signal and a desired input signal. The interfering signal (e.g., the interference) can be associated with another system such as mmWave cellular communications, radar, powerlines, etc.

At operation 1204, a filter resonates at one of the center frequencies. The resonance can be a peak or other portion of a resonance. For example, the center frequency of the notch can correspond to a center frequency of the signal, or can be offset therefrom. The resonance can include a trap of an LC network of the filter, or another capacitor according to a series-parallel circuit. For example, the filter can include a capacitor in series with an inductor to form the LC network. A pair of inductors can separate the LC network from the antenna and the amplifier, respectively. The resonance can "trap" energy in the filter so as to reduce a magnitude of a voltage at the frequency presented to the input of the amplifier. A filter impedance can dissipate the energy. The various inductors can be portions of a multi-tap inductor. For example, the multi-tap inductor can be formed along a planar surface, such as in one or more metallization layers of a semiconductor device (e.g., may be a multi-tap spiral inductor).

At operation 1206, a first and second signal are received at an amplifier gate. Each of the first and second signals can include corresponding spectral content. The amplifier can provide the respective signals to a signal processing device (e.g., a DSP circuit) to generate digital content from the spectral content. For example, the DSP circuit can identify symbols embedded in the spectral content, the signals corresponding to digital information and generating the digital information responsive to the determination of the symbols.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities (e.g., reader elements, writer elements, or magnetic media) that can operate within a system or environment. It should be understood that the systems described above can provide multiple ones of any or each of those components and these components can be provided on either a standalone machine or, in some embodiments, on multiple machines in a distributed system. Further still, bit field positions can be changed and multibit words can be used. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

The term "coupled" and variations thereof includes the joining of two members directly or indirectly to one another. The term "electrically coupled" and variations thereof includes the joining of two members directly or indirectly to one another through conductive materials (e.g., metal or copper traces). Such joining may be stationary (e.g., permanent or fixed) or moveable (e.g., removable or releasable). Such joining may be achieved with the two members coupled directly with or to each other, with the two members coupled with each other using a separate intervening member and any additional intermediate members coupled with one another, or with the two members coupled with each other using an intervening member that is integrally formed as a single unitary body with one of the two members. If "coupled" or variations thereof are modified by an additional term (e.g., directly coupled), the generic definition of "coupled" provided above is modified by the plain language meaning of the additional term (e.g., "directly coupled" means the joining of two members without any separate intervening member), resulting in a narrower definition than the generic definition of "coupled" provided above. Such coupling may be mechanical, electrical (e.g., magnetic), or fluidic. Magnetically coupled may refer to or include a presence of a linkage between two or more magnetic devices, over which a transfer of effects such as magnetic fields or forces can be conveyed, in some embodiments.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

## Claims

1. A device comprising:

   a first inductor;
   a second inductor magnetically coupled with the first inductor and with an amplifier;
   a notch filter electrically coupled between the first inductor and the second inductor; and
   wherein the amplifier is configured to amplify a plurality of radio frequency signals, wherein a bandwidth of the plurality of radio frequency signals exceeds 1.5 gigahertz (GHz).

2. The device of claim 1, wherein:
   the second inductor is directly coupled to a gate terminal of the amplifier.

3. The device of claim 1 or 2, further comprising:
   a multi-tap inductor, wherein:

   a first tap pair of the multi-tap inductor corresponds to a first terminal of the first inductor and a second terminal of the first inductor; and/or
   a second tap pair of the multi-tap inductor corresponds to a third terminal of the second inductor and a fourth terminal of the second inductor.

4. The device of claim 3, wherein:

   the first terminal couples with the third terminal; and/or
   a terminal of the notch filter couples with the first terminal and the third terminal;
   and/or another terminal of the notch filter couples with a reference voltage.

5. The device of claim 4, further comprising a capacitor having:

   a first terminal which couples with the first terminal and the third terminal; and/or
   a second terminal which electrically couples with a third inductor, wherein the third inductor couples with a third tap pair of the multi-tap inductor.

6. The device of any preceding claim 3 to 5, wherein the multi-tap inductor is a multi-tap spiral inductor.

7. The device of any preceding claim, wherein the device is formed along a planar surface of a semiconductor die.

8. A system comprising:

   a first inductor, having a first terminal and a second terminal;
   a second inductor having a first terminal electrically coupled with the second terminal of the first inductor at a first node, the second inductor magnetically coupled with the first inductor;
   a filter coupled with the first node; and
   an amplifier electrically coupled with a second terminal of the second inductor, the amplifier to amplify a plurality of signals, each signal of the plurality of signals corresponding with at least one center frequency.

9. The system of claim 8, wherein:
   the plurality of signals comprise signals corresponding to center frequencies in a 5 GHz band and signals corresponding to center frequencies in a 6 GHz band.

10. The system of claim 8 or 9, wherein:

    a first center frequency corresponding with a first signal of the plurality of signals exceeds five gigahertz (GHz); and
    a second center frequency corresponding with a second signal of the plurality of signals exceeds the first center frequency by more than one GHz.

11. The system of any preceding claim 8 to 10, comprising:
    a multi-tap inductor, wherein:

    a first tap of the multi-tap inductor corresponds to the first terminal of the first inductor;
    a second tap of the multi-tap inductor corresponds to the second terminal of the first inductor;
    a third tap of the multi-tap inductor corresponds to the first terminal of the first inductor; and
    a fourth tap of the multi-tap inductor corresponds to the second terminal of the first inductor.

12. A method comprising:

    receiving, from an antenna, a plurality of signals, each signal of the plurality of signals corresponding with at least one center frequency;
    resonating, at a filter, at a first center frequency of a first signal of the plurality of signals, the filter:

    being separated from the antenna by a first inductor;
    being separated from an amplifier by a second inductor; and
comprising a first capacitor in series with at least a third inductor; and receiving, at a gate terminal:

    a second signal of the plurality of signals, the second signal comprising second spectral content corresponding to a second center frequency; and
    a third signal of the plurality of signals, the third signal comprising third spectral content corresponding to a third center frequency.

13. The method of claim 12, further comprising:

    determining first digital content from the second spectral content; and
    determining second digital content from the third spectral content.

14. The method of any preceding claim 12 or 13, wherein the second spectral content and the third spectral content are received, simultaneously, by the antenna.

15. The method of any preceding claim 12 to 14, wherein the first inductor, the second inductor, and the third inductor of the filter are portions of a multi-tap spiral inductor formed along a planar surface.

FIG. 1

EP 4 550 664 A1

FIG. 2

EP 4 550 664 A1

FIG. 3

FIG. 4

FIG. 5

FIG. 6

FIG. 7

FIG. 8

EP 4 550 664 A1

FIG. 11

1100
1104
1102
1106
1108

FIG. 10

1000
1004
1002
1006
1008
1012
1010

FIG. 9

900
902
904

1200

1202
Receive signals corresponding to various center frequencies

1204
Resonate at one of the center frequencies

1206
Receive first and second signals at an amplifier gate

FIG. 12

EP 4 550 664 A1

Europäisches
Patentamt

European
Patent Office

Office européen
des brevets

# EUROPEAN SEARCH REPORT

| | Application Number |
|---|---|
| | EP 24 20 7766 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2018/132314 A1 (WISPRY INC [US])<br>19 July 2018 (2018-07-19)<br>* page 6, line 20 - page 7, line 10;<br>figures 4A,7,9,18-22 *<br>* page 9, line 29 - page 10, line 24 *<br>* page 15, line 7 - page 17, line 5 *<br>* page 18, line 25 - page 19, line 11 *<br>----- | 1,2,6-8,<br>12,15 | INV.<br>H03H7/01 |
| X | US 2021/409047 A1 (CHEN KUN [US] ET AL)<br>30 December 2021 (2021-12-30)<br>* paragraph [0075] - paragraph [0082];<br>figures 1,2A-C,8A,16 *<br>* paragraph [0098] - paragraph [0102] *<br>* paragraph [0132] - paragraph [0138] *<br>* paragraph [0172] - paragraph [0173] *<br>* paragraph [0182] *<br>----- | 1,3-5,<br>8-14 | |

| | TECHNICAL FIELDS SEARCHED (IPC) |
|---|---|
| | H03H |

The present search report has been drawn up for all claims

| Place of search | Date of completion of the search | Examiner |
|---|---|---|
| Munich | 14 March 2025 | Mesplede, Delphine |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

........................................................................

& : member of the same patent family, corresponding
document

## ANNEX TO THE EUROPEAN SEARCH REPORT
## ON EUROPEAN PATENT APPLICATION NO.

EP 24 20 7766

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2025

| Patent document cited in search report | Publication date | Patent family member(s) | Publication date |
|---|---|---|---|
| WO 2018132314 A1 | 19-07-2018 | CN 110495096 A | 22-11-2019 |
| | | EP 3568913 A1 | 20-11-2019 |
| | | WO 2018132314 A1 | 19-07-2018 |
| US 2021409047 A1 | 30-12-2021 | CN 113872551 A | 31-12-2021 |
| | | DE 102021206757 A1 | 30-12-2021 |
| | | GB 2599986 A | 20-04-2022 |
| | | JP 2022013726 A | 18-01-2022 |
| | | KR 20220002120 A | 06-01-2022 |
| | | TW 202220378 A | 16-05-2022 |
| | | US 2021408992 A1 | 30-12-2021 |
| | | US 2021409047 A1 | 30-12-2021 |

EPO FORM P0459

For more details about this annex : see Official Journal of the European Patent Office, No. 12/82